(19) Europäisches Patentamt
European Patent Office
Office européen des brevets

(11) **EP 4 507 459 A1**

(12) **EUROPEAN PATENT APPLICATION**
published in accordance with Art. 153(4) EPC

(43) Date of publication:
**12.02.2025 Bulletin 2025/07**

(21) Application number: **23825818.0**

(22) Date of filing: **01.03.2023**

(51) International Patent Classification (IPC):
*H05K 1/11* (2006.01)

(52) Cooperative Patent Classification (CPC):
**H05K 1/11; H05K 1/18**

(86) International application number:
**PCT/CN2023/079007**

(87) International publication number:
**WO 2023/246160 (28.12.2023 Gazette 2023/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.06.2022 CN 202210705661**

(71) Applicant: **ZTE Corporation
Shenzhen, Guangdong 518057 (CN)**

(72) Inventor: **ZHANG, Hongyan
Shenzhen, Guangdong 518057 (CN)**

(74) Representative: **Canzler & Bergmeier
Patentanwälte
Partnerschaft mbB
Despag-Straße 6
85055 Ingolstadt (DE)**

(54) **CIRCUIT BOARD AND CIRCUIT BOARD ASSEMBLY**

(57) The present disclosure provides a circuit board, comprising a plurality of array connection points arranged to form a connection point array and a plurality of array holes arranged to form a hole array; at least some of the array connection points are electrically connected to at least one array hole; a standard array and a virtual array having the same structure are defined in the circuit board, and the corresponding structural directions in the standard array and the virtual array are parallel to each other; each array connection point is located at a corresponding standard point position in the standard array; the hole array comprises a plurality of standard array holes and at least one offset array hole; each standard array hole is located in a corresponding virtual point position in the virtual array; and a first side of each offset array hole is adjacent to a first lead, and the offset array hole is offset towards a second side by a first preset distance relative to a corresponding virtual point position in the virtual array, wherein the second side is an opposite side of the first side.

FIG. 3

EP 4 507 459 A1

**Description**

CROSS REFERENCE TO RELATED APPLICATIONS

The present disclosure claims the priority to Chinese Patent Application No. 202210705661.9 filed with the CNIPA on June 21, 2022, the contents of which are incorporated herein by reference in their entirety.

TECHNICAL FIELD

The present disclosure relates to, but is not limited to, the technical field of circuit boards.

BACKGROUND

A Printed Circuit Board (PCB) is provided with connection points for connection with other structures, and some of the connection points may need to be arranged in an array in some cases. For example, the pads on the PCB which are configured to be connected to a Ball Grid Array (BGA) package chip need to be arranged in an array corresponding to the BGA. Therefore, the vias (BGA vias) connected to the pads (the connection points) need to be arranged in an array the same as that of the pads (although the array of the vias may deviate from the array of the pads).

That is, the positions of the vias are fixed, resulting in fixed distances between adjacent vias. Therefore, the number of leads capable of being arranged between the adjacent vias is limited, which reduces density of the PCB, and increases the number of layers of the PCB and a cost of the PCB.

SUMMARY

The present disclosure provides a circuit board and a circuit board assembly.

In a first aspect, the present disclosure provides a circuit board, including a plurality of array connection points arranged in a connection point array, and a plurality of array holes arranged in a hole array, with at least part of the plurality of array connection points electrically connected to at least one of the plurality of array holes. A standard array and a virtual array, which have same structures, are defined in the circuit board, and corresponding structural directions in the standard array and the virtual array are parallel to each other; each of the plurality of array connection points is located at a corresponding standard point position in the standard array; the hole array includes a plurality of standard array holes and at least one offset array hole; each of the plurality of standard array holes is located at a corresponding virtual point position in the virtual array; and a first side of each offset array hole is adjacent to a first lead, and the offset array hole deviates from a corresponding virtual point position in the virtual array towards a second side by a first predetermined distance, with the second side being an opposite side relative to the first side.

In a second aspect, the present disclosure provides a circuit board assembly, including any of the circuit boards provided in the present disclosure; and electronic devices disposed on the circuit board, with at least part of the electronic devices electrically connected to the array connection points.

BRIEF DESCRIPTION OF DRAWINGS

Fig. 1 is a schematic diagram illustrating a positional relationship between array connection points and point positions in a circuit board according to the present disclosure;
Fig. 2 is a schematic diagram illustrating another positional relationship between array connection points and point positions in a circuit board according to the present disclosure;
Fig. 3 is a schematic diagram illustrating a positional relationship between array holes and leads in a circuit board according to the present disclosure;
Fig. 4 is a schematic diagram illustrating another positional relationship between array holes and leads in a circuit board according to the present disclosure;
Fig. 5 is a schematic diagram of a partial cross-sectional structure at a back-drilled hole serving as an offset array hole in a circuit board according to the present disclosure;
FIG. 6 is a schematic diagram illustrating a positional relationship between the array connection points and array holes in the circuit board shown in FIG. 1;
FIG. 7 is a schematic diagram illustrating a positional relationship between the array connection points and array holes in the circuit board shown in FIG. 2;
Fig. 8 is a schematic diagram illustrating a dimensional relationship between array holes and leads in a circuit board according to the present disclosure; and
Fig. 9 is a block diagram of a circuit board assembly according to the present disclosure.

DETAIL DESCRIPTION OF EMBODIMENTS

In order to enable those of ordinary skill in the art to better understand the technical solutions of the present disclosure, a circuit board and a circuit board assembly provided in the implementations of the present disclosure are described in detail below with reference to the drawings.

The present disclosure will be described more fully below with reference to the drawings, but the implementations illustrated may be embodied in different forms, and the present disclosure should not be interpreted as being limited to the implementations described herein. Rather, the implementations are provided to make the present disclosure thorough and complete, and are intended to enable those of ordinary skill in the art to fully understand the scope of the present disclosure.

The drawings for the implementations of the present disclosure are intended to provide a further understanding of the implementations of the present disclosure and constitute a part of the specification. Together with exemplary implementations of the present disclosure, the drawings are used to explain the present disclosure, but do not constitute any limitation to the present disclosure. The above and other features and advantages will become more apparent to those of ordinary skill in the art from the description of exemplary implementations with reference to the drawings.

The present disclosure can be described with reference to plans and/or cross-sectional views with the aid of idealized schematic diagrams of the present disclosure. Accordingly, the exemplary drawings may be modified according to manufacturing techniques and/or tolerances.

All the implementations of the present disclosure and the features therein may be combined with each other if no conflict is incurred.

The terms used herein are merely used to describe exemplary implementations, and are not intended to limit the present disclosure. The term "and/or" used herein includes one associated listed item or any and all combinations of more than one associated listed items. The terms "one" and "the" used herein which indicate a singular form are intended to include a plural form, unless expressly stated in the context. The terms "include" and "be made of" used herein indicate the presence of the described features, integers, operations, elements and/or components, but do not exclude the presence or addition of one or more other features, integers, operations, elements, components and/or combinations thereof.

Unless otherwise defined, all terms (including technical and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein

The implementations of the present disclosure are not limited to those illustrated by the drawings, but include modifications to configuration formed based on a manufacturing process. Thus, regions shown in the drawings are illustrative, and shapes of the regions shown in the drawings illustrate exemplary shapes of regions of elements, but are not intended to make limitations.

In a first aspect, the present disclosure provides a circuit board.

A circuit board, also referred to as printed circuit board (PCB), may include a plurality of layers each provided with some leads, and the leads may be electrically connected to structures at other layers through holes. Thus, when electronic devices are disposed on the circuit board, the electronic devices may be electrically connected with each other through the leads according to desired relationships.

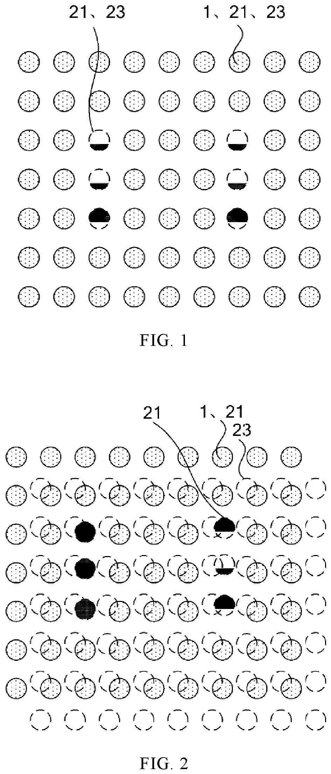

Referring to FIG. 1 to FIG. 8, the circuit board according to the present disclosure includes a plurality of array connection points 1 arranged in a connection point array, and a plurality of array holes arranged in a hole array, with at least part of the array connection points 1 electrically connected to at least one array hole. A standard array and a virtual array, which have same structures, are defined in the circuit board, and corresponding structural directions in the standard array and the virtual array are parallel to each other; each array connection point 1 is located at a corresponding standard point position 21 in the standard array; the hole array includes a plurality of standard array holes 31 and at least one offset array hole 32; each standard array hole 31 is located at a corresponding virtual point position 23 in the virtual array; and a first side of each offset array hole 32 is adjacent to a first lead 41, and the offset array hole 32 deviates from the corresponding virtual point position 23 in the virtual array towards a second side by a first predetermined distance, with the second side being an opposite side relative to the first side.

The circuit board according to the present disclosure includes the plurality of array connection points 1 arranged in the connection point array and the plurality of array holes arranged in the hole array.

The array connection points 1 are structures for electrical connection to other structures (e.g., electronic devices), and are generally located on a surface layer of the circuit board. For example, the array connection points 1 may be pads provided on a surface of the circuit board.

The array holes are hole structures (such as a blind hole and a through hole) in the circuit board, and have a conductive material formed therein for enabling signal transmission between different layer structures.

Referring to FIG. 1 and FIG. 2, the standard array and the virtual array are further defined in the circuit board.

The standard array is a complete array formed by a plurality of standard point positions 21; and in terms of plane position, each array connection point 1 is arranged at a standard point position 21 in the standard array, that is, the connection point array is at least a part of the standard array.

It should be understood that, referring to FIG. 1 and FIG. 2, each array connection point 1 is necessarily located at a standard point position 21, but each standard point position 21 is not necessarily provided with an array connection point 1, that is, the connection point array may not "fill" all the point positions of the standard array, and some positions in the standard array may be "empty", which may be set according to a form of another structure to be connected to the array connection points 1.

The virtual array is a complete array formed by a plurality of virtual point positions 23, and the structure of the virtual array is the same as that of the standard array, that is, the virtual array and the standard array are the same in number, spacing, relative position of the point positions; and moreover, the corresponding structural directions in the standard array and the virtual array are parallel to each other, for example, when both the standard array and the virtual array have row structures, a row direction of the standard array and a row direction of the virtual array are parallel to each other.

Thus, referring to FIG. 1, the virtual array and the standard array coincide with each other; or, referring to FIG. 2, the virtual array as a whole is "translated (not rotated)" relative to the standard array by a certain distance.

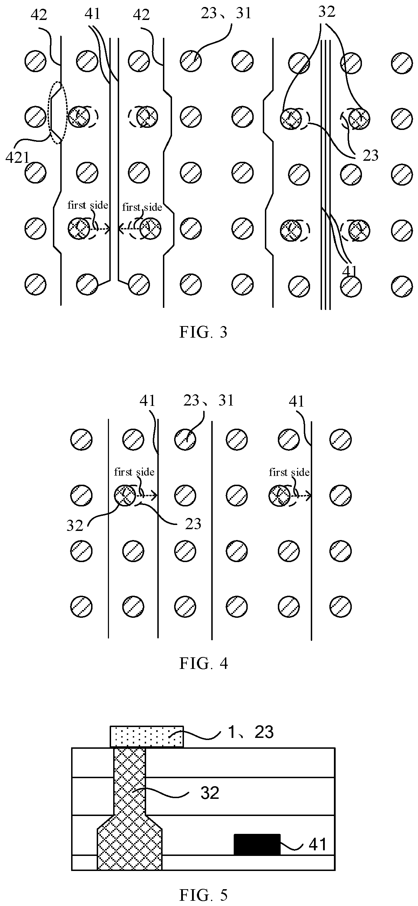

In the present disclosure, each array hole corresponds to a respective one virtual point position 23 of the virtual array, and is "substantially" located at the corresponding virtual point position 23. Exemplarily, the array holes are divided into two types, that is, the standard array holes 31 and the offset array holes 32. Referring to FIG. 3 and FIG. 4, the standard array hole 31 is located at the corresponding virtual point position 23; and a first lead 41 is provided adjacent to the offset array hole 32 on the first side of the offset array hole 32 (that is, there is no other structures such as a lead and a hole between the offset array hole 32 and the first lead 41), and the offset array hole 32 is not exactly located at the corresponding virtual point position 23, but deviates from the virtual point position 23 by the first predetermined distance towards the second side which is far away from the first lead 41.

It should be understood that the standard array hole 31 being located at the virtual point position 23 does not mean that the standard array hole 31 "absolutely" coincides with the virtual point position 23, and a very small positional deviation (e.g., a deviation significantly smaller than the first predetermined distance) is allowed as long as the purpose is to locate the standard array hole 31 at the virtual point position 23.

It should be understood that the first predetermined distance is desired to be very small relative to an original distance between adjacent virtual point positions 23, for example, the first predetermined distance is no more than one fifth of the original distance between the adjacent virtual point positions 23.

It should be understood that, referring to FIG. 3, each offset array hole 32 is provided with a respective first lead 41 and a respective first side, that is, different offset array holes 32 may deviate towards different second sides relative to different first leads 41; and for one lead, part of the array holes adjacent to the lead may take the lead as the respective first leads and thus serve as the offset array holes 32, while the remaining array holes adjacent to the lead may not take the lead as the respective first leads and thus serve as the standard array holes 31.

It should be understood that each array hole necessarily corresponds to a virtual point position 23 (located at the virtual point position 23 or deviates from the virtual point position 23 by the first predetermined distance), but each virtual point position 23 is not necessarily provided with a corresponding array hole, that is, the hole array may not "fill" all the point positions of the virtual array, and some positions of the virtual array may be "empty".

That is, in the present disclosure, the array holes "as a whole" are arranged in the hole array which is the same as the connection point array (but the hole array does not necessarily coincide with the connection point array in terms of position), but some of the offset array holes 32 adjacent to the first leads 41 are slightly away from the first leads 41 relative to the virtual point positions 23, thereby increasing the distances from the offset array holes 32 to the first leads 41.

It should be understood that the standard point positions 21 are in one-to-one correspondence with the virtual point positions 23, but since the array connection points 1 are not in one-to-one correspondence with the standard point positions 21 and the array holes are not in one-to-one correspondence with the virtual point positions 23, the array connection points 1 and the array holes do not necessarily have a corresponding relationship therebetween, that is, the array connection points 1 and the array holes may be different both in number and in relative position.

At least part of the array connection points 1 are electrically connected to one or more array holes for transmitting signals to each other.

That is, at least part of the plurality of array connection points 1 need to be electrically connected to the array hole(s).

As described above, since the array connection points 1 are not necessarily in one-to-one correspondence with the array holes, the array connection points 1 and the array holes may have various corresponding (electrical connection) relationships therebetween.

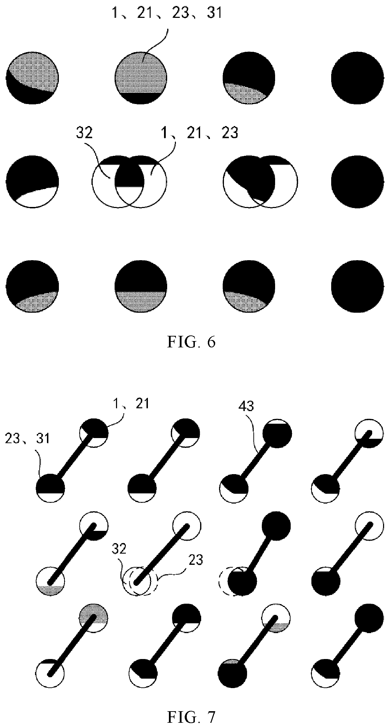

For example, referring to FIG. 6 and FIG. 7, in an implementation of the present disclosure, each array connection point 1 corresponds to and is electrically connected to one array hole. For another example, instead of being electrically connected to an array hole corresponding to the position, each array connection point 1 is electrically connected to another array hole around the array hole corresponding to the position. For another example, referring to FIG. 7, the array connection point 1 denoted by "1" may be electrically connected to the array hole on the lower left side. For another example, part of the array connection points 1 may not be electrically connected to any array hole, or one array connection point 1 may be electrically connected to a plurality of array holes, or one array hole may be electrically connected to a plurality of array connection points 1, or part of the array holes may not be electrically connected to any array connection point 1.

It can be seen that electrical connection between the array holes and the array connection points 1 may be set as required, and will not be described in detail here.

It should be understood that the circuit board may be provided with other connection points than the array connection points 1 and other holes than the array holes, which will not be described in detail here.

In the present disclosure, the array connection points 1 are arranged in the connection point array, the array holes are arranged in the hole array, and the hole array "as a whole" is in the same form as the connection point array, so that the electrical connection between the array holes and the array connection points 1 can be realized; meanwhile, the offset array hole 32 adjacent to the first lead 41 in the hole array slightly deviates in a direction away from the first lead 41, so that the distance between the offset array hole 32 and the first lead 41 is increased, and the number of the leads capable of being arranged between the adjacent array holes is increased, thereby increasing the density of the circuit board, and reducing the number of layers needed by the circuit board and manufacturing cost of the circuit board.

In some implementations, the hole array includes a plurality of rows and a plurality of columns; and each first lead 41 is disposed between two adjacent columns of array holes.

Referring to FIG. 1 to FIG. 4, in an implementation of the present disclosure, the array holes may be arranged in a plurality of rows and a plurality of columns, and the first leads 41 of all the offset array holes 32 extend between "two adjacent columns" of array holes.

It should be understood that the above row and the above column merely indicate two relative directions crossing each other, and the two relative directions are not necessarily perpendicular to each other, and are independent of an orientation and a position of the circuit board (for example, the longitudinal direction in each drawing is not necessarily the column direction).

In some implementations, the standard array is a matrix, and rows of the matrix are perpendicular to columns of the matrix.

In an implementation of the present disclosure, furthermore, referring to FIG. 1 and FIG. 2, the rows and the columns may be perpendicular to each other, so that the standard array is in a form of a "matrix", and certainly, the virtual array is also in the form of a "matrix".

In some implementations, the array connection points 1 are pads for connection to a BGA.

In an implementation of the present disclosure, the array connection points 1 are the pads for connection to a BGA package chip, that is, each pad is configured to be connected to one solder ball in the BGA of the BGA package chip. Accordingly, the array holes are "BGA vias" for transmitting signals of the BGA package chip.

In some implementations, the virtual point positions 23 corresponding to at least part of the array holes are positions of the pads, and the first predetermined distance is smaller than the sum of a radius of the pads and a radius of the array holes; and the at least part of the array holes are electrically connected to the pads having the positions coincident with the positions of the at least part of the array holes.

Referring to FIG. 6, in an implementation of the present disclosure, the virtual point positions 23 corresponding to the array holes may be the positions of the pads (also the array connection points 1 and the standard point positions 21) electrically connected to the array holes, that is, the virtual array coincides with the standard array, and a Plated over Filled Via (POFV) design is adopted.

Thus, the standard array holes 31 are disposed at the corresponding pads, and may be directly electrically connected to the pads; and the offset array holes 32 deviate from the virtual point positions 23 (i.e., the pads) by the first predetermined distance, and since the first predetermined distance is smaller than the sum of the radius of the pads and the radius of the array holes, the offset array holes 32 at least partially overlap the pads after the deviation, and may be directly electrically connected to the pads.

Or, in some other implementations, the virtual point positions 23 corresponding to at least part of the array holes deviate from the positions of the pads by a second predetermined distance, which is greater than the sum of the radius of the pads and the radius of the array holes; and the at least part of the array holes are electrically connected to the pads through connecting leads 43.

Referring to FIG. 7, in another implementation of the present disclosure, the second predetermined distance may be provided between the virtual point positions 23 corresponding to the array holes and the pads, that is, the virtual array is moved relative to the standard array by the second predetermined distance, and the second predetermined distance is greater than the sum of the radius of the pads and the radius of the array holes, such that the pads (also the array connection points 1 and the standard point positions 21) do not directly coincide with the array holes, and the pads need to be electrically connected to the array holes through the connecting leads 43 (as described above, in this case, the connection relationship between the pads and the array holes is not limited to the form illustrated by the FIG. 7).

Referring to FIG. 7, since the positional deviation of the offset array hole 32 is equivalent to a positional change of one end of the connecting lead 43, a length and an angle of the connecting lead 43 connected to the offset array hole 32 are slightly different from those of the connecting lead 43 connected to the standard array hole 31 (the lengths of some connecting leads 43 are reduced while the lengths of some connecting leads 43 are increased), but those differences are too small to generate a substantive impact on the corresponding signal transmission.

It should be understood that the array connection points 1 are not limited to the form of the pads described above. For example, the array connection points 1 may be configured to be connected to pins in an array in other electronic devices.

In some implementations, at least part of the offset array holes 32 are back-drilled holes.

In an implementation of the present disclosure, the offset array holes 32 may be the back-drilled holes (the holes having the back surfaces thereof subjected to a back drilling process). Referring to FIG. 5, an aperture of the hole is increased in the back drilling process, such that the back-drilled hole, as compared with other holes, has a smaller distance to an adjacent lead under the condition of a same position, and is more likely to be beyond a process capability or cause a defect. Therefore, the back-drilled holes may be used as the offset array holes 32.

In some implementations, the hole array includes at least one offset hole group; each offset hole group includes two adjacent offset array holes 32, and the first side of any one of the two adjacent offset array holes 32 is adjacent to the other offset array hole 32; and the two adjacent offset array holes 32 in each offset hole group are both back-drilled holes.

In an implementation of the present disclosure, in a case where two adjacent array holes having a lead disposed therebetween are both back drilled holes (i.e., double-sided back drilled holes), the two adjacent array holes both serve as the offset array holes 32 (taken as one offset hole group), and separately deviate in opposite directions (that is, the first sides of the two offset array holes 32 face each other, and the second sides of the two offset array holes 32 are opposite to each other). In the case where both the two adjacent array holes are the back-drilled holes, a distance therebetween is necessarily smaller, so that both the two adjacent array holes may serve as the offset array holes 32 for increasing the distance therebetween as much as possible.

It should be understood that the offset array holes 32 may be the back-drilled holes but not all back-drilled holes necessarily serve as the offset array holes, that is, for each back-drilled hole, whether the back-drilled hole serves as the offset array hole may be set as required.

It should be understood that the holes capable of serving as the offset array holes 32 are not limited to the form of the back drilled hole, for example, blind holes, deep V holes, and other vias may also serve as the offset array holes 32.

It should be understood that a relationship of the back drilled holes and the offset array holes 32 is not limited to the aforesaid examples. For example, for two adjacent back drilled holes having a lead disposed therebetween, merely one of the two back drilled holes serves as the offset array hole 32, or neither of the two back drilled holes serves as the offset array hole 32. For another example, for two adjacent array holes having a lead disposed therebetween, if merely one of the two array holes is the back-drilled hole (i.e., a single-sided back-drilled hole), the back-drilled hole serves as the offset array hole 32. For another example, the other array holes than the back-drilled holes serve as the offset array holes 32.

In some implementations, at least part of the first leads 41 are differential lines.

In an implementation of the present disclosure, the first leads 41 corresponding to the offset array holes 32 may be differential lines for transmitting differential signals (the holes electrically connected to the first lead are high-speed signal holes). The differential signals are generally high-frequency signals and are more likely to interfere with other structures, so distances between the differential lines and the other structures are desired to be larger; and moreover, the differential lines are necessarily "paired", a pair of differential lines is preferably disposed between adjacent array holes (a double-line mode), so as to increase the density of the circuit board and reduce the number of layers and the cost of the circuit board. Therefore, the wiring space of the differential lines is generally more compact, and thus needs to be enlarged with some methods.

It should be understood that the first leads 41 are not limited to the above form. For example, in a case where merely one differential line (a single line mode) is disposed between adjacent array holes, the array holes may include the offset array hole 32. For another example, other leads (e.g., a ground line GND) may be also used as the first leads 41.

In some implementations, the second sides of at least part of the offset array holes 32 are adjacent to a second lead 42, an extension direction of the second lead 42 is perpendicular to a direction pointing from the first sides to the second sides, and the second lead 42 forms bent structures 421 at positions adjacent to the offset array holes 32, with the bent structures 421 protruding in a direction away from the offset array holes 32.

Referring to FIG. 3, a lead (the second lead 42) may be provided adjacent to the offset array holes 32 on the second sides of the offset array holes 32, and the extension direction of the whole second lead 42 is perpendicular to the direction pointing from the first sides to the second sides, e.g., the extension direction may be a column direction.

Since the offset array holes 32 deviate towards the second sides (for example, deviating in the row direction), as compared with the standard array holes 31 (e.g., the standard array holes 31 in the same column as the offset array holes 32), the distances between the offset array holes 32 and the second lead 42 are smaller. In order to make the distances between the offset array holes 32 and the second lead 42 meet a requirement, referring to FIG. 3, the second lead 42 may be bent away from the offset array holes 32 (that is, forming the bent structures 421) at local positions corresponding to the offset array holes 32.

It should be understood that each offset array hole 32 is provided with a corresponding second lead 42, each lead may simultaneously serve as the respective second leads 42 of a plurality of offset array holes 32, and directions of the first sides of different offset array holes 32 may be different. Therefore, referring to FIG. 3, bending directions of the bent structures 431 may be different.

In some implementations, the hole array includes at least one offset hole group; and each offset hole group includes two adjacent offset array holes 32, and the first side of any one of the two adjacent offset array holes 32 is adjacent to the other offset array hole 32.

In an implementation of the present disclosure, referring to FIG. 3, part of the array holes which are adjacent to each other and have a lead disposed therebetween may simultaneously serve as the offset array holes 32 (for example, the array holes are the back drilled holes), and deviate in directions away from each other (that is, the first sides of two adjacent offset array holes 32 face each other, and the second sides of the two adjacent offset array holes 32 are opposite to each other).

In some implementations, at least part of adjacent offset array holes 32 is provided with one lead therebetween, and the lead serves as the first leads 41 of both two adjacent offset array holes 32; and/or, at least part of adjacent offset array holes 32 is provided with two leads therebetween, and the two leads respectively serve as the first leads 41 of two adjacent offset array holes 32.

In an implementation of the present disclosure, referring to FIG. 4, in a case where two adjacent offset array holes 32 deviate away from each other, merely one lead is disposed between the two adjacent offset array holes 32, and serves as the first leads 41 of both of the two adjacent offset array holes 32; or, referring to FIG. 3, two leads are disposed between the two adjacent offset array holes 32, and respectively serve as the first leads 41 of the two adjacent offset array holes 3.

It should be understood that the forms of the leads and the array holes are not limited to the above forms. For example, referring to FIG. 3, the number of the leads adjacent to the first side of the offset array hole 32 may be three or more; for example, referring to FIG. 4, merely one of two adjacent array holes is the offset array hole 32; for example, referring to FIG. 3 and FIG. 4, in a case where the number of the leads between two columns of array holes is the same as that of the leads between other two columns of array holes, merely part of the array holes serve as the offset array holes 32 (for example, merely the back drilled holes serve as the offset array holes 32), or none of the array holes are the offset array holes; and for example, referring to FIG. 4, for a lead disposed adjacent to the offset array hole 32, the lead is not bent (that is, the lead does not serve as the second lead).

It should be understood that the first predetermined distance by which the offset array hole 32 deviates may be selected according to a size range of a drilling capability (a range of a distance between a hole and a lead adjacent thereto which can ensure that no defect is generated after a drilling process).

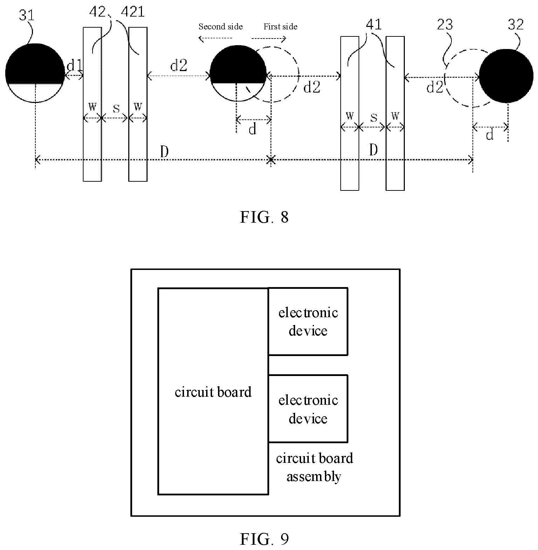

For example, referring to FIG. 8, two leads are disposed between two columns of array holes, two adjacent array holes are both the offset array holes 32 (so both the two leads are the first leads 41), and on the second side of each offset array hole, there are sequentially provided the bent structures 421 of two second leads 42 and one standard array hole 31 (taking the offset array hole 32 on the left side in FIG. 8 as an example), then on the second side of the offset array hole 32, it is desired to satisfy the following formula (1):

$$D = 2w+s+d1+d2+2Rp+d \quad (1);$$

on the first side of the offset array hole 32, it is desired to satisfy the following formula (2):

$$D = 2w+s+2d2+2Rp-2d \quad (2);$$

where, referring to FIG. 8, D is a distance between adjacent virtual point positions 23 in a row direction, d is the first predetermined distance by which the offset array hole 32 deviates in the row direction, w is a line width of the leads, s is a distance between two adjacent leads in the row direction, d1 is a distance between the standard array hole 31 and the adjacent lead in the row direction, Rp is the radius of the array holes, and d2 is a distance between the offset array hole 32 and the adjacent lead in the row direction.

It can be seen that, since the virtual point positions 23 are arranged in an array, the distances D between the different virtual point positions 23 are necessarily the same, and sizes of all other same parameters are desired to be the same as much as possible from the point of view of signal uniformity (for example, the distance d2 between the offset array hole 32 and the first lead 41 and the distance d2 between the offset array hole 32 and second lead 42 are desired to have a same value). Therefore, the parameters denoted by the same sign in the above formulae (1) and (2) have a same value, and by subtracting the formula (1) from the formula (2), the first predetermined distance d by which the offset array hole 32 deviates may be calculated by the following formula (3) in the case illustrated by FIG. 8:

$$d = (d2 - d1)/3 \quad (3).$$

d1 and d2 need to be respectively selected from the size ranges of the drilling capabilities (a primary drilling capability and a secondary drilling capability) of the standard array hole 31 (such as a non-back-drilled hole) and the offset array hole 32 (such as the back-drilled hole) (otherwise, a defect may be generated). After the selection of d1 and d2, the first predetermined distance d by which the offset array hole 32 deviates can be obtained according to the above formula.

It should be understood that the various sizes are not limited to the above examples. For example, in a case where the lead is disposed on the second side of the offset array hole 32 but is not bent, the distance d2 between the offset array hole 32 and the lead on the first side of the offset array hole 32 may be different from the distance d2 between the offset array hole 32 and the lead on the second side of the offset array hole 32.

It should be understood that each drawing of the present disclosure merely illustratively shows the relative positional relationships between the structures, and is not intended to limit the positions and the connection modes of the structures. For example, the leads shown in each drawing may be located in internal layers of the circuit board in practical applications (see FIG. 5, for example), so that the leads cannot be directly seen when being viewed from the top (but the leads are shown in the drawings); and for example, the leads shown in each drawing may be connected to the array holes in a way illustrated by FIG. 3 so as to achieve signal transmission with the array connection points 1, or, the leads may simply "pass" the area of the array holes without being connected to the array holes.

First Example

In a case where the array connection points of the circuit board correspond to a BGA matrix having intervals of 1mm, four outermost circles of the BGA matrix are used for leading-out of wires, so that the circuit board may include two layers, the upper layer is configured to realize the leading-out of the wires of the two outer circles of the BGA matrix, the lower layer is configured to realize the leading-out of the wires of the two inner circles of the BGA matrix, and the leads in the two outer circles are removed by back drilling at a lead layer of a high-speed line in the two inner circles.

Second Example

In a case where the array connection points of the circuit board correspond to a BGA matrix having intervals of 1mm, a lead channel can be enlarged through the deviation of the offset array holes, so that more leads can be disposed. For example, a distance between the first row of array holes and the second row of array holes is 1mm, and one lead is disposed between the two rows of array holes; a distance between the second row of array holes and the third row of array holes is 1mm, and two leads are disposed between the two rows of array holes; a distance between the third row of array holes and the fourth row of array holes is 1.2mm, and three leads are disposed between the two rows of array holes; and a distance between the fourth row of array holes and the fifth row of array holes is 0.8mm, and one lead is disposed between the two rows of array holes. The offset array holes in the fourth row deviate downwards by 0.2mm, with the result that the distance between the third row of array holes and the fourth row of array holes is increased to 1.2mm, and the distance between the fourth row of array holes and the fifth row of array holes is reduced to 0.8mm.

Third Example

In a case where the array connection points of the circuit board correspond to a matrix having intervals of 0.8mm, a lead channel can be increased through the deviation of the offset array holes, so that more leads can be disposed. For example, for two columns of array holes on the left side, a distance between the array holes in each row is 0.8mm, and for the array holes on the right side, a distance between the first row of array holes and the second row of array holes is 0.8mm, and one lead is disposed between the two rows of array holes; a distance between the second row of array holes and the third row of array holes is 0.76mm, and one lead is disposed between the two rows of array holes; a distance between the third row of array holes and the fourth row of array holes is 0.96mm, and two leads are disposed between the two rows of array holes; a distance between the fourth row of array holes and the fifth row of array holes is 0.76mm, and one lead is disposed between the two rows of array holes; a distance between the fifth row of array holes and the sixth row of array holes is 0.76mm, and one lead is disposed between the two rows of array holes; and a distance between the sixth row of array holes and the seven row of array holes is 0.76mm, and one lead is disposed between the two rows of array holes. From the third row, the offset array holes are provided to adjust the distances. Thus, for the array holes in the two columns on the left side and the array holes in each column on the right side, the distances from the second row to the seventh row are all 4mm, and it can be seen that the number of the leads disposed on the right side is greater than the number of the leads disposed on the left side by one under the condition of a same distance.

In a second aspect, referring to FIG. 9, the present disclosure provides a circuit board assembly, including: the circuit board according to any implementation of the present disclosure; and electronic devices disposed on the circuit board, with at least part of the electronic devices electrically connected to the array connection points.

Corresponding electronic devices may be disposed on the circuit board to form the circuit board assembly (or a circuit board with a relatively complete function). At least part of the electronic devices are electrically connected to the array connection points of the circuit board.

For example, the electronic devices may include a BGA package chip, which is connected to the circuit board via the array connection points (the pads).

The present disclosure discloses the exemplary implementations using specific terms, but the terms are merely used and should be merely interpreted as having general illustrative meanings, rather than for the purpose of limitation. Unless expressly stated, it is apparent to those of ordinary skill in the art that, in some examples, features, characteristics and/or elements described in connection with a particular implementation can be used alone or in combination with features, characteristics and/or elements described in connection with other implementations. Therefore, it should be understood by those of ordinary skill in the art that various changes in the forms and the details can be made without departing from the scope of the present disclosure of the appended claims.

**Claims**

1. A circuit board, comprising a plurality of array connection points arranged in a connection point array, and a plurality of array holes arranged in a hole array, with at least part of the plurality of array connection points electrically connected to at least one of the plurality of array holes; wherein,

   a standard array and a virtual array, which have same structures, are defined in the circuit board, and corresponding structural directions in the standard array and the virtual array are parallel to each other;
   each of the plurality of array connection points is located at a corresponding standard point position in the standard array; and
   the hole array comprises a plurality of standard array holes and at least one offset array hole; each of the plurality of standard array holes is located at a corresponding virtual point position in the virtual array; and a first side of each offset array hole is adjacent to a first lead, and the offset array hole deviates from a corresponding virtual point position in the virtual array towards a second side by a first predetermined distance, with the second side being an opposite side relative to the first side.

2. The circuit board of claim 1, wherein

   the hole array comprises a plurality of rows and a plurality of columns; and
   each first lead is disposed between two adjacent columns of array holes.

3. The circuit board of claim 1, wherein
   the standard array is a matrix, and rows of the matrix are perpendicular to columns of the matrix.

4. The circuit board of claim 1, wherein
   second sides of at least part of offset array holes are adjacent to a second lead, an extension direction of the second lead is perpendicular to a direction pointing from first sides to the second sides, and the second lead forms bent structures at positions adjacent to the offset array holes, with the bent structures protruding in a direction away from the offset array holes.

5. The circuit board of claim 1, wherein the hole array comprises at least one offset hole group; and
   each offset hole group comprises two adjacent offset array holes, and the first side of any one of the two adjacent offset array holes is adjacent to the other one of the two adjacent offset array holes.

6. The circuit board of claim 5, wherein
   at least part of adjacent offset array holes is provided with one lead therebetween, and the lead serves as first leads of both two adjacent offset array holes.

7. The circuit board of claim 5, wherein
   at least part of adjacent offset array holes is provided with two leads therebetween, and the two leads respectively serve as first leads of two adjacent offset array holes.

8. The circuit board of claim 5, wherein

   at least part of adjacent offset array holes is provided with one lead therebetween, and the lead serves as first leads of both two adjacent offset array holes;
   and
   at least part of adjacent offset array holes is provided with two leads therebetween, and the two leads respectively serve as first leads of two adjacent offset array holes.

9. The circuit board of claim 1, wherein
   at least part of first leads are differential lines.

10. The circuit board of claim 1, wherein
    at least part of offset array holes are back-drilled holes.

11. The circuit board of claim 10, wherein the hole array comprises at least one offset hole group;

    each offset hole group comprises two adjacent offset array holes, and the first side of any one of the two adjacent offset array holes is adjacent to the other one of the two adjacent offset array holes; and
    the two adjacent offset array holes in each offset hole group are both back-drilled holes.

**12.** The circuit board of claim 1, wherein
the plurality of array connection points are pads for
connection to a ball grid array.

**13.** The circuit board of claim 12, wherein
virtual point positions corresponding to at least part
of the plurality of array holes are positions of the
pads, and the first predetermined distance is smaller
than a sum of a radius of a pad and a radius of an
array hole; and the at least part of the plurality of array
holes are electrically connected to the pads having
the positions coincident with positions of the at least
part of the plurality of array holes.

**14.** The circuit board of claim 12, wherein
virtual point positions corresponding to at least part
of the plurality of array holes deviate from positions of
the pads by a second predetermined distance, and
the second predetermined distance is greater than a
sum of a radius of a pad and a radius of an array hole;
and the at least part of the plurality of array holes are
electrically connected to the pads through connecting leads.

**15.** A circuit board assembly, comprising:

the circuit board of any one of claims 1 to 14; and
electronic devices disposed on the circuit board,
with at least part of the electronic devices electrically connected to array connection points.

21、23    1、21、23

FIG. 1

21    1、21
23

FIG. 2

FIG. 3

FIG. 4

FIG. 5

1、21、23、31

FIG. 6

1、21

23、31

43

32

23

FIG. 7

FIG. 8

FIG. 9

## INTERNATIONAL SEARCH REPORT

International application No.

**PCT/CN2023/079007**

### A. CLASSIFICATION OF SUBJECT MATTER

H05K 1/11(2006.01)i

According to International Patent Classification (IPC) or to both national classification and IPC

### B. FIELDS SEARCHED

Minimum documentation searched (classification system followed by classification symbols)

IPC:H05K

Documentation searched other than minimum documentation to the extent that such documents are included in the fields searched

Electronic data base consulted during the international search (name of data base and, where practicable, search terms used)

CNTXT; CNABS; ENTXT; ENTXTC; DWPI; CNKI: 电路板, 通孔, 焊盘, 阵列, 偏移, 移动, 间距, 密度, 布线, 间隔, circuit board, via, pad, array, offset, movement, pitch, density, routing, spacing

### C. DOCUMENTS CONSIDERED TO BE RELEVANT

| Category* | Citation of document, with indication, where appropriate, of the relevant passages | Relevant to claim No. |
|---|---|---|
| X | CN 102111957 A (JUNIPER NETWORKS INC.) 29 June 2011 (2011-06-29) description, paragraphs 2-25, and figures 1A-5 | 1-15 |
| X | CN 110874518 A (KABUSHIKI KAISHA NIHON MICRONICS) 10 March 2020 (2020-03-10) description, paragraphs 2-18 and 52-110, and figures 4-13 | 1-15 |
| A | US 2003183419 A1 (LSI LOGIC CORPORATION) 02 October 2003 (2003-10-02) entire document | 1-15 |
| A | CN 203228481 U (SHENZHEN WATER WORLD TECHNOLOGY CO., LTD.) 09 October 2013 (2013-10-09) entire document | 1-15 |
| A | US 2002084312 A1 (INTEL CORP.) 04 July 2002 (2002-07-04) entire document | 1-15 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **24 May 2023** | **01 June 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/079007**

| Patent document cited in search report | | | Publication date (day/month/year) | Patent family member(s) | | | Publication date (day/month/year) |
|---|---|---|---|---|---|---|---|
| CN | 102111957 | A | 29 June 2011 | EP | 2339901 | A1 | 29 June 2011 |
| | | | | US | 2011155434 | A1 | 30 June 2011 |
| | | | | US | 8273994 | B2 | 25 September 2012 |
| CN | 110874518 | A | 10 March 2020 | US | 2020050732 | A1 | 13 February 2020 |
| | | | | US | 10776556 | B2 | 15 September 2020 |
| | | | | TW | 202018301 | A | 16 May 2020 |
| | | | | TWI | 724447 | B | 11 April 2021 |
| | | | | JP | 2020027487 | A | 20 February 2020 |
| | | | | JP | 7123692 | B2 | 23 August 2022 |
| | | | | KR | 20200019080 | A | 21 February 2020 |
| | | | | KR | 102289322 | B1 | 11 August 2021 |
| US | 2003183419 | A1 | 02 October 2003 | US | 6762366 | B1 | 13 July 2004 |
| | | | | US | 7051434 | B2 | 30 May 2006 |
| CN | 203228481 | U | 09 October 2013 | None | | | |
| US | 2002084312 | A1 | 04 July 2002 | US | 6622905 | B2 | 23 September 2003 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210705661